(19) Europäisches Patentamt
European Patent Office
Office européen des brevets

(11) Veröffentlichungsnummer: **0 268 941 B1**

(12) **EUROPÄISCHE PATENTSCHRIFT**

(45) Veröffentlichungstag der Patentschrift: **15.04.92**

(51) Int. Cl.5: **H01L 29/54**, H01L 21/285, H01L 21/82

(21) Anmeldenummer: **87116679.9**

(22) Anmeldetag: **11.11.87**

(54) **MOS-Feldeffekt-Transistorstruktur mit extrem flachen Source/- Drain-Zonen und Silizid-Anschlussbereichen, sowie Verfahren zu ihrer Herstellung in einer integrierten Schaltung.**

(30) Priorität: **18.11.86 DE 3639356**

(43) Veröffentlichungstag der Anmeldung:
**01.06.88 Patentblatt 88/22**

(45) Bekanntmachung des Hinweises auf die Patenterteilung:
**15.04.92 Patentblatt 92/16**

(84) Benannte Vertragsstaaten:
**AT DE FR GB IT NL**

(56) Entgegenhaltungen:
**EP-A- 0 118 709**
**US-A- 4 041 518**
**US-A- 4 343 082**
**US-A- 4 542 580**
**US-A- 4 566 914**

(73) Patentinhaber: **SIEMENS AKTIENGESELL-SCHAFT**
**Wittelsbacherplatz 2**
**W-8000 München 2(DE)**

(72) Erfinder: **Mazuré-Espejo, C. A., Dr. rer. nat.**
**Heinrich-Egger-Strasse 10**
**W-8011 Kirchseeon(DE)**
Erfinder: **Neppl, Franz, Dr. rer. nat.**
**St.-Ouirin-Platz 6**
**W-8000 München 90(DE)**

**Beschreibung**

Die Erfindung betrifft eine zwischen Feldoxidbereichen einer integrierten Schaltung angeordnete MOS-Feldeffekt-Transistorstruktur mit extrem flachen Source/Drain-Zonen im Siliziumsubstrat und selbstjustierten, aus Silizid bestehenden Source/Drain-Anschlüssen und einer, durch eine Isolationsschicht vom Substrat getrennten, über der zwischen den Source/Drain-Zonen liegenden Kanalzone angeordneten, mit Flankenoxid versehenen Gate-Elektrode. Die Erfindung betrifft ferner komplementäre MOS (CMOS)-Transistoren enthaltende hochintegrierte Schaltungen mit die aktiven Transistorbereiche trennenden Feldoxidbereiche, mit extrem flachen Source/Drain-Zonen im Substrat, mit selbstjustierten, aus Silizid bestehenden Source/Drain-Anschlüssen und mit Gate-Elektroden, die isoliert vom Substrat über den zwischen den Source/Drain-Zonen der n-Kanal- bzw. p-Kanal-Transistoren liegenden Kanälen angeordnet sind und Flankenoxide aufweisen, sowie Verfahren zu ihrer Herstellung.

Bei der weiteren Miniaturisierung von MOS-Ic's erhöhten sich die Probleme bezüglich der parasitären Serienwiderstände, der Drainfeldstärke (sog. hot carrier effects) und der Planarisierung. Insbesondere die Planarisierung ist vor der Durchführung der Kontaktlochätzung wegen der sonst sich ergebenden mehreren unterschiedlichen Kontaktlochtiefen und der begrenzten Selektivität der Ätzung zum Substrat sehr stark eingeschränkt.

Zur Reduzierung der Drainfeldstärke sind die sog. LDD-Techniken ( = lightly doped drain-Techniken) weit verbreitet, die aber erhebliche Serienwiderstände zur Folge haben. Zur Lösung des Serienwiderstandsproblems wurden daher die sog. SALICIDE-Techniken ( = self aligned silicide-Techniken), wie sie beispielsweise in einem Bericht von C.K. Lau, Y.C. See, D.B. Scott, J.M. Bridges, S.M. Perna und R.D. Davis im IEDM Techn. Digest, S. 714-177 (1982) erwähnt werden, sowie eine Kombination der selbstjustierten Silizierung (Abscheidung von Metall auf Siliziumoberflächen) mit der lightly doped drain-Technik vorgeschlagen. Diese Technik wird als sog. SOLID-Technik ( = silicide on lightly doped drain) bezeichnet und ist aus einem Bericht von M. Horiuchi und K. Yamaguchi aus dem Solid State Electronics 28 (1985) S. 465-472 bekannt.

Der Nachteil all dieser Techniken besteht darin, daß die vorher erzeugte - wegen der Kurzkanaleigenschaften notwendigerweise flachen - Diffusionsgebiete durch die Silizidreaktion teilweise wieder verbraucht werden und damit die Gefahr von Substratkurzschlüssen, insbesondere bei nicht homogenen Reaktionen, besteht.

Aufgabe der Erfindung ist es, eine MOS-Feldeffekt-Transistorstruktur zu schaffen, bei der die Technologie der bekannten Verfahren so verbessert ist, daß trotz flacher Source/Drain-Zonen eine Silizierung zur Reduzierung der Schichtwiderstände möglich ist, ohne daß Substratkurzschlüsse entstehen können. Außerdem sollen eine möglichst planare Struktur, die für eine Mehrlagenverdrahtung geeignet ist, entstehen, wobei die Kontaktlochätzung und damit die Selektivität dieser Ätzung zum Substrat unkritisch ist.

Gelöst wird diese Aufgabe durch die eingangs genannte MOS-Feldeffekttransistor-Struktur, welche erfindungsgemäß dadurch gekennzeichnet ist, daß zwischen Gate-Elektrode und den Feldoxidbereichen durch selektive Epitaxie erzeugte einkristalline dotierte Siliziumschichten angeordnet sind, die als Diffusionsquellen zur Erzeugung der Source/Drain-Zonen im Substrat gedient haben und die Anschlußbereiche zu den darüber angeordneten, aus Silizid bestehenden Source/Drain-Anschlüssen bilden.

Durch die Verwendung der selektiven Epitaxie wird eine Vorplanarisierung der Transistorstruktur erreicht, die eine Reihe von Device-Vorteilen beinhaltet. Die Anwendung der selektiven Silizium-Epitaxie ist in der CMOS-Technologie z.B. aus einem Aufsatz von S. Nagao, K. Higashitani, Y. Akasaka und H. Nakata im Technical Digest IEDM (1984) auf den Seiten 593-596 zu entnehmen. Dort wird die selektive Epitaxie dazu benutzt, in Isolationsschichten geätzte Gräben mit einkristallinem Silizium aufzufüllen und die LOCOS-Isolationstechnik durch Unterbinden der sog. bird's beak zu verbessern.

Ein weiteres Verfahren der selektiven Silizium-Epitaxie für hochintegrierte CMOS-Schaltungen ist aus einem Aufsatz von K.A. Sabine und H.A. Kemhadjian aus dem IEEE Electron Device Letters, EDL-6 (1985) S. 43-46 zu entnehmen. Die selektive Epitaxie dient hier dazu, in Siliziumsubstrate geätzte Wannen mit einkristallinen, entsprechend dotierten Siliziumschichten aufzufüllen, um begrenzte Wannenbereiche mit niedrigen Oberflächenkonzentrationen, niedrigen Schichtwiderständen und vernachlässigbarer lateraler Ausdiffusion zu erhalten.

Die erfindungsgemäße Struktur hat gegenüber den bekannten MOS-bzw. CMOS-Strukturen den Vorteil, daß durch das homogene Auffüllen der Bereiche zwischen Gate und Feldoxid mit einkristallinem Silizium, wobei die Gateflächen mit Oxid bedeckt bleiben und von der späteren Silizierung ausgeschlossen sind, die neue Source/Drain-Herstellung durch die Optimierung der Source/Drain-Kontakte vom Gate-Bereich weitgehend entkoppelt wird. Dabei ergeben sich folgende Verbesserungen und Möglichkeiten:

1. Da die Source/Drain-Implantation in die epitaktisch aufgewachsene Siliziumschicht stattfindet, wird kein Implantationsdamage an der Gatekante verursacht. Dadurch wird die Güte der Gateoxidqualität bewahrt und eine mögliche Degradationsursache vermieden.

2. Bei üblichen Diffusions-Zeit-Produkten (D . t) sind durch die Ausdiffusion aus dem hochdotierten epitaktischen Source/Drain-Gebiet sehr flache effektive Diffusionsgebiete im Substrat erzielbar. Geringer Unterschwellströme (Subthreshold) sowie verminderte Punch-Through-Effekte sind deshalb zu erwarten. Bei den Anti-Punch-Kanal-Implantationen wird eine geringere Dosis benötigt. Dies führt zu einer Reduktion der Junction-Kapazität. Die relativ niedrige Dotierung in dem ausdiffundierten Source/Drain-Gebiet vermindert die Drainfeldstärke an der Gatekante, die eine der wichtigsten Degradationsursachen darstellt.

3. Die Kombination mit der self aligned silicid-Technik (SALICIDE-Technik) wirkt sich auf die parasitären Serienwiderstände aus. Es kann eine Silizierung durchgeführt werden, trotz der flachen effektiven Diffusionsgebiete. Die Gefahr der Substratkurzschlüsse bei möglichen inhomogenen SilizidReaktionen wird durch die Epitaxie-Schicht verhindert, die trotz flacher effektiver Diffusionsgebiete als Pufferschicht wirkt. Folglich sind höhere Siliziddicken möglich, um niedrigere Widerstände zu erzielen.

4. Die epitaktisch aufgewachsenen Source/Drain-Gebiete schaffen eine verbesserte Voraussetzung für die Planarisierung und die Mehrlagenverdrahtung. Die Einschränkung beim Verfließprozeß mit Bor-Phosphor-Silikatglas wird verringert. Aufgrund dessen werden die Anforderungen an die Selektivität der Kontaktlochätzung vermindert. Der Abstand Kontaktloch zur Feldoxidkante wird unkritisch, da keine Substratkurzschlußgefahr mehr besteht.

5. Aufgrund der flachen Source/Drain-Ausdiffusion im Substrat ist bei gleichbleibenden Wannendotierungen und -tiefen eine verminderte Latch-up-Anfälligkeit zu erwarten. Der Grund dafür ist die höhere Gummelzahl bzw. die Erhöhung der parasitären Emitter-Kollektor-Durchbruchspannung $U_{CEO}$.

Weitere Ausgestaltungen der Erfindung, insbesondere Verfahren zur Realisierung der MOS- bzw. CMOS-Struktur in integrierten Schaltungen ergeben sich aus den Unteransprüchen.

Im folgenden soll anhand der Figuren 1 bis 12 die erfindungsgemäße MOS-Feldeffekttransistor-Struktur sowie Verfahren zu ihrer Herstellung in einer integrierten Schaltung noch näher erläutert werden. Dabei zeigen

die Figur 1

ein Schnittbild durch eine MOS-Feldeffekttransistorstrukturhälfte, um den Aufbau der Schichten deutlich zu machen,

die Figur 2

das in der Epitaxieschicht und im Substrat herrschende Dotierungsprofil,

die Figuren 3 bis 7

Schnittbilder über die wesentlichen Verfahrensschritte bei der Herstellung eine CMOS-Schaltung, wobei die Dotierung der Epitaxieschicht nach der Abscheidung durch Ionenimplantation erfolgt, und

die Figuren 8 bis 12

Schnittbilder über die wesentlichen Verfahrensschritte bei der Herstellung einer CMOS-Schaltung, wobei die Dotierung des jeweiligen Kanaltyps bereits bei der epitaktischen Abscheidung mit vorgenommen wird. Gleiche Teile sind in in den Figuren mit gleichen Bezugszeichen versehen.

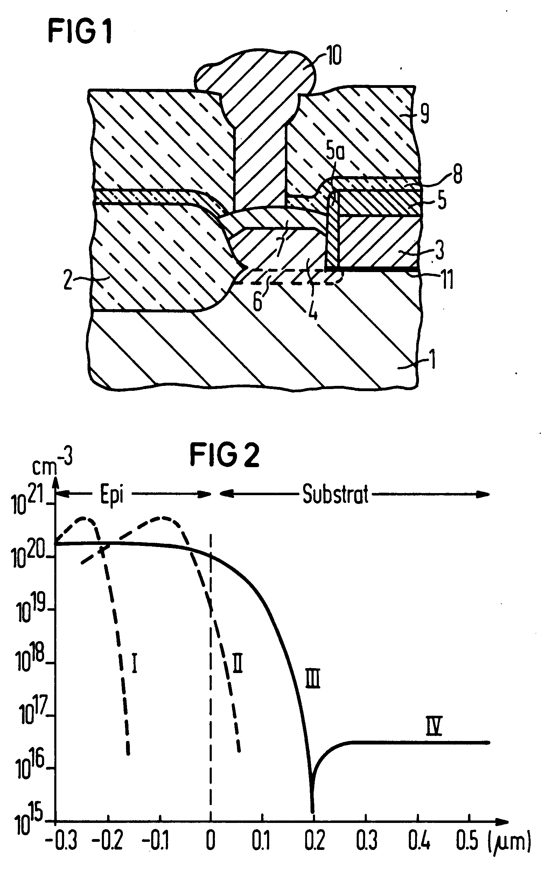

Figur 1: Der Prozeß zur Herstellung der erfindungsgemäßen Struktur läuft bis zur Herstellung der Metallabscheidung für den Silizidanschluß in den Source/Drain-Bereichen wie ein self aligned silicide-Prozeß (siehe Bericht von C.K. Lau et al), bei dem die Gate-Elektrode (3) durch die aufgebrachte Oxidschicht (5, 5a) von der Silizierung ausgeschlossen bleibt und die Source/Drain-Ionenimplantation noch nicht durchgeführt worden ist. Dann erfolgt auf die bereits freigeätzten Source/Drain-Gebiete (6) des Substrates 1 die selektive Abscheidung einer undotierten epitaktischen (also monokristallinen) Siliziumschicht 4, die den Bereich zwischen der Gate-Elektrode 3 (mit Flankenoxid 5a) und dem Feldoxid 2 auffüllt. Die Ausfüllung 4 der Source/Drain-Bereiche ist durch die selektive Epitaxie sehr homogen und einkristallin. Die Facettenbildung am Rande des Source- bzw. Drain-Gebietes (4), ein Effekt der selektiven Epitaxie, stellt in diesem Fall kein großes Hindernis dar, da dies den aktiven Transistorbereich nicht berührt. Außerdem kommt es bei der Kontaktierung hauptsächlich auf die Reinheit der Oberfläche an. Nach dem Abscheiden der Epitaxieschicht 4 werden die Dotieratome für die Source/Drain-Zone 6 in den einkristallinen Siliziumbereich 4 implantiert und so weit diffundiert, daß die p/n-Übergänge zum Substrat 1 (bzw. den Wannen) nur knapp innerhalb des ursprünglichen Mono-Siliziums (1) liegen (siehe Bereich 6). Mit dem Bezugszeichen 7 ist der Silizidanschluß, mit 8 eine Zwischenoxidschicht, mit 9 eine Bor-Phosphorglasschicht, mit 10 die aus einer Aluminium/Silizium/Titan-Legierung bestehende äußere Leiterbahn und mit 11 das Gateoxid bezeichnet.

Figur 2 zeigt das erhaltene Dotierungskonzentrationsprofil (Ordinate = Konzentration in $cm^{-3}$, Abszisse = Eindringtiefe in $\mu$m) für den Fall einer $n^+$-Source- bzw. Drain-Zone. Bei üblichen Diffusions-Zeit-Produkten (D . t) entstehen effektiv extrem flache Source/Drain-Zonen (6) mit relativ geringer Dotierungskonzentration, die für gute Kurzkanaleigenschaften (z.B. $U_T(L)$, sog. hot carriers) wichtig sind. In Figur 2 bedeuten die Kurven I und II Phosphordotierungsprofile nach der Doppelimplantation, die Kurve III das Phosphordotierungsprofil nach dem Hochtemperaturschritt und die Kurve IV das Bordotierungsprofil im Substrat.

Der für den Übergangswiderstand und Schichtwiderstand wichtige Bereich hoher Dotierungskonzentration liegt im oberen Bereich der aufgebrachten selektiven Epitaxieschicht (4) und damit außerhalb des kritischen Bereichs in der Nähe des Kanals. Der Prozeß kann mit Silzierungstechniken (Aufbringen einer Metallschicht und Silizidbildung) ergänzt werden, wobei die Gefahr von Silizium-Verbrauch in Verbindung mit flachen Diffusionsgebieten entfällt, da die selektive Epitaxieschicht die Diffusionsgebiete nach oben "verlängern", ohne die Kurzkanaleigenschaften zu verschlechtern. Außerdem findet bei der Silizierung, bedingt durch die Einkristallinität der Schicht eine einfache Reaktion statt; es treten keine Reaktionen mit Korngrenzen auf, wie es bei polykristallinem Silizium der Fall ist.

Die Reichweite der Implantation plus die D . t-Belastung müssen allerdings zwei Randbedingungen erfüllen

1. Die Implantationsenergie darf nicht so hoch sein, daß eine außergewöhnliche Maskierung nötig wird.

2. Das D . t-Produkt, das für den Anschluß zum Kanal sorgt, darf nicht so groß sein, daß es die bereits vorhandenen Dotierprofile ändert. Im wesentlichen ist man daher bei der MOS-Feldeffekttrransistor-Struktur mit nach der Abscheidung durch Implantation dotierten Epitaxieschicht auf eine Epitaxiedicke von maximal 400 nm begrenzt.

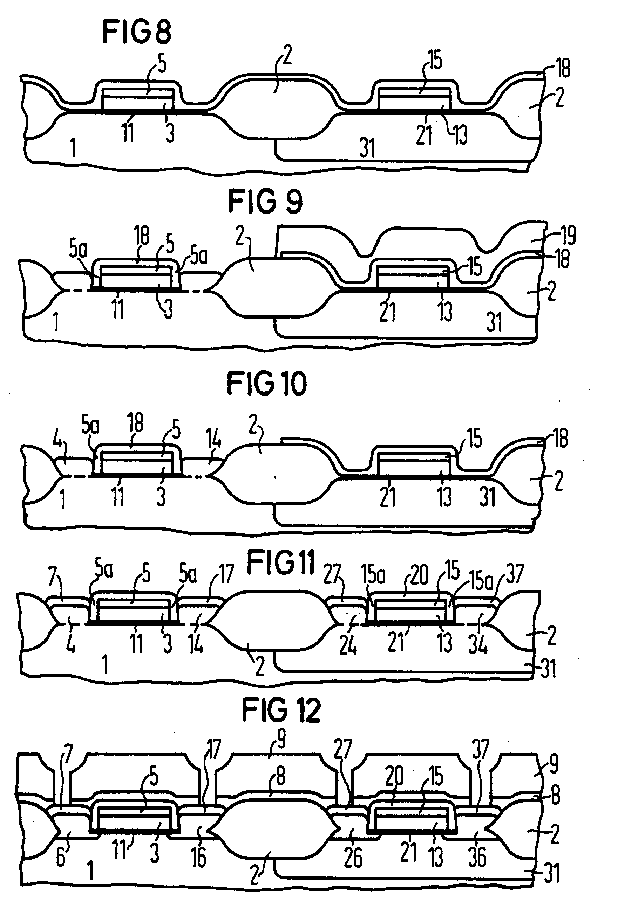

Alternativ dazu kann die Struktur auch mit dotierter Epitaxieschicht hergestellt werden, wobei eine getrennte $n^+$- bzw. $p^+$-Siliziumepitaxie in die n- bzw. p-Kanal-Bereiche erfolgt. Dadurch wird eine homogene Dotierung der Source/Drain-Gebiete und eine abrupte Dotierungsstufe zum Substrat erreicht. Die Temperaturbelastung bei der benötigten Ausdiffusion von den Source/Drain-Gebieten wird minimiert und der Source/Drain-Anschluß zum Kanalbereich erleichtert. Die Source/Drain-Implantation, falls nötig, dient dann nur für die Verringerung des Serienwiderstandes. Da die Reichweite der Implantation nicht mehr maßgebend ist, entfällt die Begrenzung auf die Epitaxiedicke. Damit wird ein zusätzlicher Freiheitsgrad bezüglich der Feldoxidationsdicke und der Vorplanarisierung gewonnen. Diese Struktur und das Verfahren zu ihrer Herstellung ist gegenüber der zuerst genannten zwar flexibler, erfordert aber eine $SiO_2$-Maskierungstechnik bei der getrennten $n^+$- und $p^+$-Epitaxie (siehe Beschreibung der Figuren 8 bis 12).

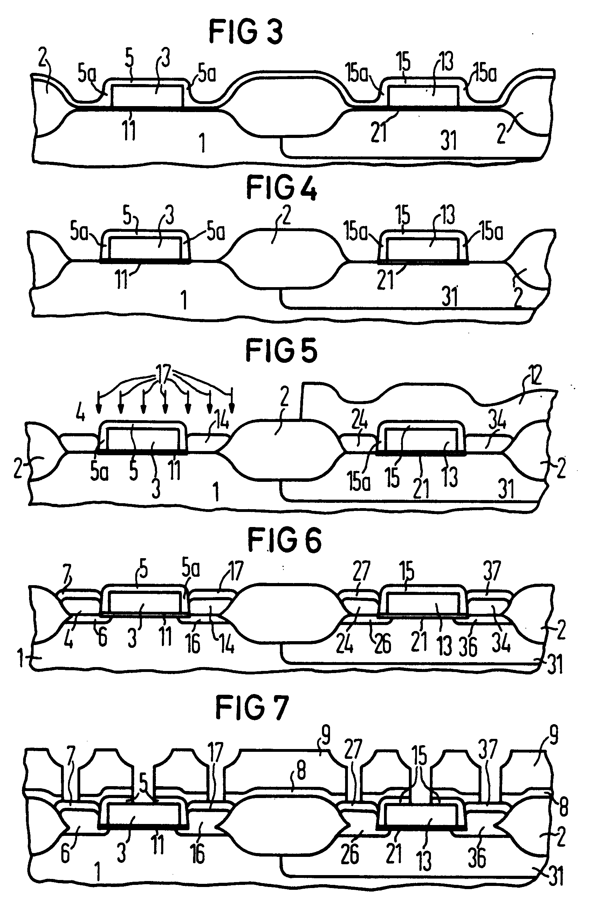

Nähere Einzelheiten zur Herstellung der Strukturen werden nun anhand von zwei Ausführungsbeispielen (A und B) noch näher erläutert. Dabei folgt bei beiden Ausführungsbeispielen der Prozeß einer konventionellen Technologie, wie sie z.B. in EP-A-0 135 163 und EP-A-0 159 617 beschrieben sind. Die erfindungsgemäße Source/Drain-Herstellung ist mit unterschiedlichen Gate-Materialien bzw. Gatetypen (Silizide, $n^+$- bzw. $p^+$-Polysilizium-Metallsilizid- oder Polysiliziumgate) vereinbar. Der besseren Übersicht wegen sind in den Figuren 3 bis 12 die Schraffuren nicht eingezeichnet worden.

Ausführungsbeispiel A (mit undotierter Epitaxieschicht)

Figur 3: Die hier dargestellte Struktur wird erhalten, nachdem die Gate-Elektroden 3, 13 auf den, von den Feldoxidbereichen 2 begrenzten aktiven Transistorbereichen des zum Beispiel p-dotieten Substrates 1 und des n-Wannenbereiches 31 strukturiert und mit den Schutzoxid- 5, 15 und Flankenoxidschichten 5a, 15a versehen worden sind. Mit 11 bzw. 21 ist das Gateoxid bezeichnet. Abschließend erfolgt ein Reoxidationsprozeß.

Figur 4 zeigt die Anordnung, nachdem die Source/Drain-Bereiche für die nachfolgende Epitaxie durch eine anisotrope Ätzung, z.B. durch Plasmaätzen in einer sauerstoffhaltigen Freon-Atmosphäre ($CF_4$) freigeätzt worden ist.

Figur 5: Nach einer kurzen Epitaxievorbehandlung (zum Beispiel einer Reinigung in organischen Lösungsmitteln und Spülen in deionisertem Wasser erfolgt nun die epitaktische Abscheidung von einkristallinem Silizium mit einer Schichtdicke im Bereich von 300 bis 400 nm ohne Dotierung. Es entstehen die Gebiete 4, 14, 24, 34. Die mit Oxid 5, 5a, 15, 15a bedeckten Gates 3, 13 bleiben von Silizium frei, desgleichen auch die Feldoxidbereiche 2. Anschließend werden die p-Kanal-Gebiete der Schaltung mit den Gates 13 mit einer Fotolackmaske 12 abgedeckt und eine Doppelimplantation (Pfeile 17) zur Erzeugung der $n^+$-Source/Drain-Bereiche 4, 14 durchgeführt. Dabei werden zunächst Phosphorionen mit einer Dosis und Energie von 8 x $10^{15}$ cm$^{-2}$ und 70 keV und dann mit 160 keV in die Schichten 4, 14 implantiert. Nach Entfernung der Fotolackschicht 12 werden nun die n-Kanal-Gebiete mit den Gates 3 mit einer erneuten Fotolackmaske abgedeckt und nach einer Voramorphisierung der Source/Drain-Bereiche durch eine Doppel-Silizium-Ionenimplantation (2 x $10^{15}$ Si$^+$cm$^{-2}$, 100 keV und 150 keV) die Source/Drain-Implantation durchgeführt. Dabei werden zunächst Bor-Ionen mit einer Dosis und Energie von 5 x $10^{15}$ cm$^{-2}$ und 25 keV und dann mit 70 keV in die Schichten 24 und 34 implantiert. Diese Vorgänge sind im einzelnen nicht dargestellt.

Die Figur 6 zeigt die Anordnung nach dem Entfernen der zuletzt aufgebrachten Fotolackmaske und nach dem Silizieren der Source/Drain-Flächen (4, 14, 24, 34). Beim Silizieren wird eine z.B. aus Tantal oder Titan bestehende Metallschicht oder das entsprechende Metallsilizid selektiv auf den freien Siliziumoberflächen niedergeschlagen. Beim nachfolgenden Hochtemperaturschritt bilden sich die Silizidschichten 7, 17, 27, 37 und durch gemeinsamen Ausdiffusion aus den Source/Drain-Bereichen 4, 14, 24, 34 die Source/Drain-Zonen 6, 16, 26, 36. Beim Hochtemperaturschritt wird die Temperatur auf 900°C eingestellt; die Dauer der Temperaturbehandlung beträgt ca. 30 Minuten.

Die Figur 7 zeigt die fertiggestellte CMOS-Anordnung, bei der in bekannter Weise die Zwischenoxide, bestehend aus einer durch Zersetzung von Tetraethylorthosilikat (TEOS) in 100 nm Dicke entstandene $SiO_2$-Schicht 8 und aus einer Bor-Phosphorsilikatglasschicht 9 in 800 nm Dicke aufgebracht und bei 900°C 40 Minuten lang einem Verfließprozeß unterworfen worden sind. In diesen Zwischenoxidschichten werden dann durch Kontaktlochfototechnik und -ätzung Kontaktlöcher erzeugt, und die aus Aluminium/Silizium/Titan bestehende äußere Leiterbahnebene (10 in Figur 1) angeschlossen. Diese Prozeßschritte sind im wesentlichen bekannt und aus den obengenannten europäischen Patentanmeldungen zu entnehmen.

Ausführungsbeispiel B (mit dotierter Epitaxieschicht)

In dieser Prozeßvariante wird erfindungsgemäß die getrennte Erzeugung von $n^+$- und $p^+$-Epitaxie-Schichten durchgeführt. Im Vergleich zur Version A ermöglicht diese Variante eine Erhöhung der Epitaxie-Schichtdicke und eine Verminderung der Temperaturbelastung.

Figur 8: Es wird auch hier von der in Figur 3 abgebildeten Struktur ausgegangen. Anstelle des Reoxidationsschrittes erfolgt ein $SiO_2$-Abscheidung 18 durch thermische Zersetzung von Tetraethylorthosilikat in einer Schichtdicke von 150 nm.

Figur 9: Zur Maskierung der p-Kanalbereiche wird nun eine Fotolackmaske 19 aufgebracht und mittels eines anisotropen Ätzprozesses die Source/Drain-Gebiete der n-Kanal-Bereiche freigeätzt. Dabei entstehen auch die Flankenoxide 5a (spacer) an der Gate-Elektrode 3.

Figur 10: Nach Entfernung der Fotolackmaske 19 und nach der Epitaxie-Vorbehandlung erfolgt die selektive $n^+$-Epitaxieabscheidung von Silizium in einer Schichtdicke im Bereich von 300 bis 500 nm. Es entstehen die Source/Drain-Bereiche 4, 14, die mit Phosphor dotiert sind ($10^{19} cm^{-3}$).

Figur 11: Nach der Aufoxidation auf 25 nm (Oxidschciht 20) wird nun eine Fototechnik zur Maskierung der n-Kanal-Bereiche, die Freiätzung der Source/Drain-Gebiete der p-Kanal-Bereiche mit der Flankenoxidbildung 15a durchgeführt. Nach Entfernung der Fotolackstruktur und Epitaxievorbehandlung erfolgt jetzt die selektive $p^+$-Epitaxie (24, 34), ebenfalls in einer Schichtdicke im Bereich von 300 bis 500 nm mit Bor als Dotierstoff ($10^{19} cm^{-3}$). Diese Schritte sind im einzelnen nicht dargestellt; sie verlaufen ähnlich wie bei Figur 9 und 10 beschrieben. Die 25 nm-Oxidschicht 20 auf den n-Kanalbereichen wird entfernt und die Silizierung der Source//Drain-Gebiete 4, 14, 24, 34 vorgenommen. Es entstehen die Metallsilizidschichten 7, 17, 27, 37.

Figur 12: Die Fertigstellung der Anordnung erfolgt wie bei Figur 7 beschrieben. Durch den Verfließprozeß bei 900°C, 40 Minuten Dauer, werden die Dotierstoffe (Phosphor, Bor) aus den Bereichen 4, 14, 24, 34 in das Substrat 1 eindiffundiert, wobei die Source/Drain-Zonen 6, 16, 26, 36 entstehen.

**Patentansprüche**

1. Zwischen Feldoxidbereichen (2) einer integrierten Schaltung angeordnete MOS-Feldeffekt-Transistorstruktur mit extrem flachen Source/Drainzonen (6) im Siliziumsubstrat (1) und selbstjustierten, aus Silizid bestehenden Source/Drain-Anschlüssen (7) und einer, durch eine Isolationsschicht (11) vom Substrat (1) getrennten, über der zwischen den Source/Drainzonen (6) liegenden Kanalzone angeordneten, mit Flankenoxid (5a) versehenen GateElektrode (3), **dadurch gekennzeichnet,** daß zwischen der Gate-Elektrode (3) und den Feldoxidbereichen (2) durch selektive Epitaxie erzeugte einkristalline, dotierte Siliziumschichten (4) angeordnet sind, die als Diffusionsquellen zur Erzeugung der Source/Drainzonen (6) im Substrat (1) gedient haben und die Anschlußbereiche zu den darüber angeordneten, aus Silizid bestehenden Source/Drain-Anschlüssen (7) bilden.

2. Komplementäre MOS(CMOS)-Transistoren enthaltende hochintegrierte Schaltung mit die aktiven Transistorbereiche trennenden Feldoxidbereichen (2), mit extrem flachen Source/Drainzonen (6, 16, 26, 36) im Substrat (1), mit selbstjustierten, aus Silizid bestehenden Source/ Drain-Anschlüssen (7, 17, 27, 37) und mit Gate-Elektroden (3, 13), die isoliert vom Substrat (1) über den zwischen den Source/Drainzonen (6, 16, 26, 36) der n-Kanal- bzw. p-Kanal-Transistoren liegenden Kanälen angeordnet sind und Flankenoxide (5a, 15a) aufweisen, **dadurch gekennzeichnet,** daß zwischen den Gate-Elektroden (3, 13) des jeweiligen Transistortyps und den, den jeweiligen Transistor begrenzenden Feldoxidbereichen (2) eine durch selektive Epitaxie erzeugte einkristalline dotierte Siliziumschicht (4, 14, 24, 34) angeordnet ist, die

die Diffusionsquelle zur Erzeugung der Source- bzw. Drainzonen (6, 16, 26, 36) im Siliziumsubstrat (1) gebildet haben und

als Verbindung zu dem aus Silizid bestehenden Anschlußbereich (7, 17, 27, 37) für die Source- bzw. Drainzone dient.

3. Hochintegrierte CMOS-Schaltung nach Anspruch 2, **dadurch gekennzeichnet,** daß die durch selektive Epitaxie erzeugte einkristalline Siliziumschicht (4, 14, 24, 34) eine maximale Dicke von 400 nm aufweist und ihre Dotierung so eingestellt ist, daß durch sie die Dotierungsprofile im Substrat (1) nicht geändert werden.

4. Hochintegrierte CMOS-Schaltung nach Anspruch 2, **dadurch gekennzeichnet,** daß die durch selektive Epitaxie erzeugte einkristalline Siliziumschicht (4, 14, 24, 34) eine Dicke im Bereich von 300 bis 500 nm aufweist und die Dotierung im oberen Bereich der Schicht homogen verläuft und zum Substrat (1) hin eine abrupte Dotierungsstufe aufweist.

5. Verfahren zum Herstellen einer CMOS-Transistoren enthaltenden integrierten Schaltung nach Anspruch 2 oder 3, **gekennzeichnet durch** den Ablauf der folgenden Verfahrensschritte:

   a) Erzeugen der Feldoxidbereiche (2) nach dem sogenannten LOCOS-Verfahren auf dem, mit p- bzw. n-Wannen für den jeweiligen Transistortyp versehenen Siliziumsubstrat (1),
   b) Durchführung der Gateoxidation (11, 21),
   c) Aufbringen und Strukturieren der mit einer $SiO_2$-Schicht (5, 15) versehenen Gate-Elektroden (3, 13) und Erzeugen der Flankenoxide (5a, 15a) and den Gate-Elektroden (3, 13) durch Oxidation,
   d) anisotrope Freiätzung der für die Source/Drainzonen (6, 16, 26, 36) der Schaltung vorgesehenen Bereiche des Substrats (1),
   e) selektive epitaktische Abscheidung einer undotierten, einkristallinen Siliziumschicht (4, 14, 24, 34) auf den freigeätzten Substratoberflächen (1) in einer Schichtdicke im Bereich von 300 bis 400 nm,
   f) Durchführung einer Ionenimplantation (17) mit Ionen vom ersten Leitungstyp in die undotierte epitaktische Siliziumschicht (4, 14) zur Erzeugung der Source/Drainzonen (6, 16) vom ersten Leitungstyp nach vorheriger Fotolack-Maskierung (12) des Transistorbereiches mit den Source/Drainzonen (26, 36) vom zweiten Leitungstyp,
   g) Entfernung der Fotolackmaske (12),
   h) Durchführung einer weiteren Ionenimplantation vom zweiten Leitungstyp in die undotierte epitaktische Siliziumschicht (24, 34) zur Erzeugung der Source/Drainzonen (26, 36) vom zweiten Leitungstyp nach vorheriger Fotolack-Maskierung des Transistorbereiches mit den Source/Drainzonen (6, 16) vom ersten Leitungstyp,
   i) Entfernung der Fotolackmaske,
   j) Silizierung der Source/Drain-Oberflächen (7, 17, 27, 37) der epitaktischen Siliziumschicht (4, 14, 24, 34),
   k) Durchführung eines Hochtemperaturschrittes zur gemeinsamen Ausdiffusion der Source/Drainzonen (6, 16, 26, 36) beider Transistortypen,
   l) Erzeugung von Zwischenisolationsschichten (8, 9), Öffnen von Kontaktlöchern zu den Source/Drain Anschlußbereichen (7, 17, 27, 37) und den Gate-Elektroden (3, 13) und Durchführung der Metallisierung (10) in bekannter Weise.

6. Verfahren nach Anspruch 5, **dadurch gekennzeichnet,** daß zwischen den Verfahrensschritten g) und h) eine Voramorphisierung der Source/Drainbereiche (26, 36) durch Implantation von Silizium-Ionen durchgeführt wird.

7. Verfahren nach Anspruch 5 oder 6, **dadurch gekennzeichnet,** daß jeweils beim Einbringen von Fremdstoffen Doppelimplantationen durchgeführt werden, wobei zuerst mit niedrigerer Energie implantiert wird.

8. Verfahren zum Herstellen einer CMOS-Transistoren enthaltenden integrierten Schaltung nach Anspruch 2 oder 4, **gekennzeichnet durch** den Ablauf der folgenden Verfahrensschritte:

   a) Erzeugen der Feldoxidbereiche (2) nach dem sog. LOCOS-Verfahren auf dem, mit p- bzw. n-Wannen für den jeweiligen Transistortyp versehenem Siliziumsubstrat (1),
   b) Durchführung der Gateoxidation (11, 21),
   c) Aufbringen und Strukturieren der mit einer $SiO_2$-Schicht (5, 15) versehenen Gate-Elektroden (3, 13) der Schaltung,
   d) Abscheidung einer $SiO_2$-Schicht (18) und Durchführung einer Fotolacktechnik (19) zur $SiO_2$-Maskierung des Transistorbereiches mit den Source/Drainzonen (26, 36) vom zweiten Leitungstyp,

e) anisotrope Freiätzung der für die Source/Drainzonen (6, 16) vom ersten Leitungstyp vorgesehenen Substratoberflächen,

f) Erzeugen der Gate-Flankenoxide (5a),

g) Entfernung der Fotolackmaske (19),

h) selektive epitaktische Abscheidung einer einkristallinen Siliziumschicht (4, 14) mit Dotierstoffen vom ersten Leitungstyp auf den freigeätzten Substratoberflächen in einer Schichtdicke im Bereich von 300 bis 500 nm,

i) Durchführung eines Oxidationsprozesses zur Erzeugung eines Schutzoxides (20),

j) Aufbringen einer Fotolackmaske auf die Transistorbereiche vom ersten Leitungstyp (6, 16),

k) anisotrope Freiätzung der für die Source/Drainbereiche (26, 36) vom zweiten Leitungstyp vorgesehenen Substratoberflächen,

l) Erzeugen der Gate-Flankenoxide (15a),

m) Entfernung der Fotolackmaske,

n) selektive epitaktische Abscheidung einer einkristallinen Siliziumschicht (24, 34) mit Dotierstoffen vom zweiten Leitungstyp auf den freigeätzten Substratoberflächen in einer Schichtdicke im Bereich von 300 bis 500 nm,

o) Silizierung der Source/Drainoberflächen der epitaktischen Siliziumschicht (4, 14, 24, 34) nach Entfernung des Schutzoxides (20) auf dem Transistorbereich vom ersten Leitungstyp,

p) Durchführung eines Hochtemperaturschrittes zur gemeinsamen Ausdiffusion der Source/Drainzonen beider Transistortypen,

q) Erzeugen von Zwischenisolationsschichten (8, 9), Öffnen von Kontaktlöchern zu den Source/Drain-Anschlußbereichen (7, 17, 27, 37) und Gate-Elektroden (3, 13) und Durchführung der Metallisierung in bekannter Weise.

9. Verfahren nach einem der Ansprüche 5 bis 8, **dadurch gekennzeichnet,** daß als Dotierstoff für den ersten Leitungstyp Phosphor und für den zweiten Leitungstyp Bor verwendet wird.

10. Verfahren nach einem der Ansprüche 5 bis 9, **dadurch gekennzeichnet,** daß die Hochtemperaturschritte zur gemeinsamen Ausdiffusion der Dotierstoffe bei 900 °C mindestens 30 Minuten lang durchgeführt werden.

11. Verfahren nach einem der Ansprüche 5 bis 10, **dadurch gekennzeichnet,** daß die Silizierung der Source/Drainanschlüsse (4, 14, 24, 34) durch Abscheidung eines hochschmelzenden Metalles, vorzugsweise von Tantal oder Titan, durch Kathodenzerstäubung (Sputtern) und anschließender Temperung erfolgt.

12. Verfahren nach einem der Ansprüche 5 bis 11, **dadurch gekennzeichnet,** daß die epitaktische Siliziumabscheidung (4, 14, 24, 34) aus der Gasphase durch thermische Zersetzung von Halogensilianen bei niedrigen Drucken erfolgt.

13. Verfahren nach einem der Ansprüche 5 bis 12, **dadurch gekennzeichnet,** daß die anisotropen Ätzprozesse durch Plasmaätzen in sauerstoff- und fluorhaltiger Atmosphäre vorgenommen werden.

14. Verfahren nach einem der Ansprüche 5 bis 13, **dadurch gekennzeichnet,** daß für die Isolationsschichten (8, 9) oder Maskieroxidschichten (5, 5a, 15, 15a, 20) eine durch Zersetzung von Tetraethylorthosilikat erzeugte $SiO_2$-Schicht verwendet wird.

**Claims**

1. MOS field-effect transistor structure arranged between field-oxide regions (2) of an integrated circuit and having extremely shallow source/drain zones (6) in the silicon substrate (1), self-aligned source/drain terminals (7) composed of silicide and a gate electrode (3) isolated from the substrate (1) by an insulation layer (11), arranged over the channel zone situated between the source/drain zones (6) and provided with side-wall oxide (5a), characterised in that there are arranged, between the gate electrode (3) and the field-oxide regions (2), single-crystal doped silicon layers (4) which are produced by selective epitaxy, which have served as diffusion sources for producing the source/drain zones (6) in the substrate (1), and which form the terminal regions for the source/drain terminals (7) arranged thereon and composed of silicide.

2. Highly integrated circuit comprising complementary MOS (CMOS) transistors and having field-oxide regions (2) isolating the active transistor regions, having extremely shallow source/drain zones (6, 16, 26, 36) in the substrate (1), having self-aligned source/drain terminals (7, 17, 27, 37) composed of silicide and having gate electrodes (3, 13) which are arranged so as to be insulated from the substrate (1) above the channels situated between the source/drain zones (6, 16, 26, 36) of the n-channel or p-channel transistors and have side-wall oxides (5a, 15a), characterised in that there is arranged, between the gate electrodes (3, 13) of the respective transistor type and the field-oxide regions (2) forming the boundary of the respective transistor, a single-crystal doped silicon layer (4, 14, 24, 34) which is produced by selective epitaxy and which has formed the diffusion source for producing the source or drain zones (6, 16, 26, 36) in the silicon substrate (1) and serves as a connection to the terminal region (7, 17, 27, 37), composed of silicide, for the source or drain zone.

3. Highly integrated CMOS circuit according to Claim 2, characterised in that the single-crystal silicon layer (4, 14, 24, 34) produced by selective epitaxy has a maximum thickness of 400 nm and its doping is adjusted in such a way that it does not alter the doping profiles in the substrate (1).

4. Highly integrated CMOS circuit according to Claim 2, characterised in that the single-crystal silicon layer (4, 14, 24, 34) produced by selective epitaxy has a thickness in the range from 300 to 500 nm and the doping in the upper region of the layer varies homogeneously and has an abrupt doping step in the direction of the substrate (1).

5. Process for producing an integrated circuit comprising CMOS transistors according to Claim 2 or 3, characterised by the sequence of following process steps:
   a) production of the field-oxide regions (2) by the so-called LOCOS process on the silicon substrate (1) which is provided with p-type or n-type wells for the respective transistor type,
   b) performance of the gate oxidation (11, 21),
   c) application and structuring of the gate electrodes (3, 13) provided with an $SiO_2$ layer (5, 15) and production of the side-wall oxides (5a, 15a) at the gate electrodes (3, 13) by oxidation,
   d) exposure by anisotropic etching of the regions of the substrate (1) provided for the source/drain zones (6, 16, 26, 36) of the circuit,
   e) selective epitaxial deposition of an undoped single-crystal silicon layer (4, 14, 24, 34) on the substrate surfaces (1) exposed by etching in a layer thickness in the range from 300 to 400 nm,
   f) performance of an ion implantation (17) with ions of the first conduction type in the undoped epitaxial silicon layer (4, 14) to produce the source/drain zones (6, 16) of the first conduction type after prior photoresist masking (12) of the transistor region containing the source/drain zones (26, 36) of the second conduction type,
   g) removal of the photoresist mask (12),
   h) performance of a further ion implantation of the second conduction type in the undoped epitaxial silicon layer (24, 34) to produce the source/drain zones (26, 36) of the second conduction type after prior photoresist masking of the transistor region containing the source/drain zones (6, 16) of the first conduction type,
   i) removal of the photoresist mask,
   j) silicizing of the source/drain surfaces (7, 17, 27, 37) of the epitaxial silicon layer (4, 14, 24, 34),
   k) performance of a high-temperature step for the combined out-diffusion of the source/drain zones (6, 16, 26, 36) of the two transistor types,
   l) production of intermediate insulation layers (8, 9), opening of vias to the source/drain terminal regions (7, 17, 27, 37) and the gate electrodes (3, 13) and performance of the metallization (10) in a known manner.

6. Process according to Claim 5, characterised in that a preliminary amorphization of the source/drain regions (26, 36) by silicon ion implantation is performed between the process steps g) and h).

7. Process according to Claim 5 or 6, characterised in that double implantations are performed every time impurities are introduced, implantation initially being carried out with lower energy.

8. Process for producing an integrated circuit comprising CMOS transistors according to Claim 2 or 4, characterised by the sequence of following process steps:
   a) production of the field-oxide regions (2) by the so-called LOCOS process on the silicon substrate (1) provided with p- or n-type wells for the respective transistor type,
   b) performance of the gate oxidation (11, 21),
   c) application and structuring of the gate electrodes (3, 13) of the circuit provided with an $SiO_2$ layer (5, 15),
   d) deposition of an $SiO_2$ layer (18) and performance of a photoresist technique (19) for $SiO_2$-masking the transistor region containing the source/drain zones (26, 36) of the second conduction type,

e) exposure by anisotropic etching of the substrate surfaces provided for the source/drain zones (6, 16) of the first conduction type,

f) production of the gate side-wall oxides (5a),

g) removal of the photoresist mask (19),

h) selective epitaxial deposition of a single-crystal silicon layer (4, 14) containing dopants of the first conduction type on the substrate surfaces exposed by etching in a layer thickness in the range from 300 to 500 nm,

i) performance of an oxidation process for producing a protective oxide (20),

j) application of a photoresist mask to the transistor regions of the first conduction type (6, 16),

k) exposure by anisotropic etching of the substrate surfaces provided for the source/drain regions (26, 36) of the second conduction type,

l) production of the gate side-wall oxides (15a),

m) removal of the photoresist mask,

n) selective epitaxial deposition of a single-crystal silicon layer (24, 34) containing dopants of the second conduction type on the substrate surfaces exposed by etching in a layer thickness in the range from 300 to 500 nm,

o) silicizing of the source/drain surfaces of the epitaxial silicon layer (4, 14, 24, 34) after removing the protective oxide (20) on the transistor region of the first conduction type,

p) performance of a high-temperature step for the combined out-diffusion of source/drain zones of the two transistor types,

q) production of intermediate insulation layers (8, 9), opening of vias to the source/drain terminal regions (7, 17, 27, 37) and gate electrodes (3, 13) and performance of the metallization in a known manner.

9. Process according to one of Claims 5 to 8, characterised in that phosphorus is used as dopant for the first conduction type and boron for the second conduction type.

10. Process according to one of Claims 5 to 9, characterised in that the high-temperature steps for the combined out-diffusion of the dopants are performed at 900°C for at least 30 minutes.

11. Process according to one of Claims 5 to 10, characterised in that the source/drain terminals (4, 14, 24, 34) are silicized by depositing a refractory metal, preferably tantalum or titanium, by cathode sputtering and subsequent heat treatment.

12. Process according to one of Claims 5 to 11, characterised in that the epitaxial silicon deposition (4, 14, 24, 34) is carried out from the gas phase by thermal decomposition of halosilanes at low pressures.

13. Process according to one of Claims 5 to 12, characterised in that the anisotropic etching processes are carried out by plasma etching in an oxygen- and fluorine-containing atmosphere.

14. Process according to one of Claims 5 to 13, characterised in that an $SiO_2$ layer produced by decomposing tetraethyl orthosilicate is used for the insulation layers (8, 9) or masking oxide layers (5, 5a, 15, 15a, 20).

## Revendications

1. Structure de transistor MOS à effet de champ, disposée entre des régions d'oxyde de champ (2) d'un circuit intégré et comportant des zones de source/drain (6) extrêmement plates dans le substrat en silicium (1) et des bornes de source/drain (7) auto-alignées et réalisées en siliciure, et une électrode de grille (3) séparée du substrat (1) par une couche isolante (11) et disposée au-dessus de la zone du canal située entre les zones de source/drain (6) et comportant un oxyde de flanc (5a), caractérisée par le fait qu'entre l'électrode de grille (3) et les régions d'oxyde de champ (2) sont disposées des couches de silicium monocristallin dopé (4), produites par épitaxie sélective et qui ont servi de sources de diffusion pour la production des zones de source/drain (6) dans le substrat (1) et forment les régions de raccordement avec les bornes de source/drain (7) disposées au-dessus d'elles et formées par un siliciure.

2. Circuit à haute densité d'intégration à transistors MOS complémentaires (CMOS) et comportant des régions d'oxyde de champ (2) séparant les régions actives de transistors, des zones de source/drain (6,16,26,36) également plates situées dans le substrat (1), des bornes de source/drain (7,17,27,37) autoalignées, constituées par un siliciure, et des électrodes de grille (3,13) qui sont disposées, en étant isolées du substrat (1), au-dessus des canaux situés entre les zones de source/drain (6,16,26,36) des transistors à canal n ou à canal p, et possèdent des oxydes de flanc (5a,15a), caractérisé par le fait qu'entre les électrodes de grille (3,13) du type de transistors et les régions d'oxyde de champ (2), qui limitent le transistor concerné, est disposée une couche de silicium monocristallin dopé (4,14,24,34), produite par épitaxie sélective et qui
a formé la source de diffusion pour la formation des zones de source et de drain (6,16,26,36) dans le substrat en silicium (1), et sert de liaison avec la zone de raccordement (7,17,27,37), constituée par le siliciure, pour la zone de source ou de drain.

3. Circuit CMOS à haute densité d'intégration suivant la revendication 2, caractérisé par le fait que la couche de silicium monocristallin (4,14,24,34), produite par épitaxie sélective, possède une épaisseur maximale de 400 nm et que son dopage est réglé de manière qu'il ne modifie pas les profils de dopage dans le substrat (1).

4. Circuit CMOS à haute densité d'intégration suivant la revendication 2, caractérisé par le fait que la couche de silicium monocristallin (4,14,24,34), produite par épitaxie sélective, possède une épaisseur située dans la gamme comprise entre 300 et 500 nm et que le dopage dans la partie supérieure de la couche est homogène et possède un gradin brusque de dopage en direction du substrat (1).

5. Procédé pour fabriquer un circuit intégré à transistors CMOS suivant la revendication 2 ou 3, caractérisé par l'exécution des étapes opératoires suivantes :
   a) production des régions d'oxyde de champ (2) selon le procédé dit LOCOS dans le substrat en silicium (1) pourvu de cuvettes de type p ou de type n pour le type respectif de transistors,
   b) exécution de l'oxydation de grille (11,21),
   c) dépôt et structuration des électrodes de grille (3,13) pourvues d'une couche de SiO$_2$ (5,15) et production des oxydes de flanc (5a,15a) sur les électrodes de grille (3,13) par oxydation,
   d) mise à nu, par corrosion anisotrope, des régions du substrat (1) prévues pour les zones de source/drain (6,,16,26,36) du circuit,
   e) dépôt épitaxial sélectif d'une couche de silicium monocristallin non dopé (4,14,24,34) sur les surfaces (1) du substrat, mises à nu par corrosion, avec une épaisseur de couche située dans la gamme de 300 à 400 nm,
   f) exécution d'une implantation ionique (17) avec des ions du premier type de conductivité dans la couche épitaxiale de siliciure non dopée (4,14) pour la formation des zones de source/drain (6,16) possédant le premier type de conductivité après masquage préalable par une photolaque (12) de la région du transistor portant les zones de source/drain (26,36) possédant le second type de conductivité,
   g) élimination du masque de photolaque (12),
   h) mise en oeuvre d'une autre implantation ionique possédant le second type de conductivité dans la couche épitaxiale de silicium non dopé (24,34) pour la production des zones de source/drain (26,36) possédant le second type de conductivité après masquage préalable par une photolaque de la région du transistor comportant les zones de source/drain (6,16) possédant le premier type de conductivité,
   i) élimination du masque de photolaque,
   j) transformation en siliciure des surfaces de source/drain (7,17,27,37) de la couche épitaxiale de silicium (4,14,24,34),
   k) exécution d'une étape de traitement à haute température pour provoquer la diffusion commune des zones de source/drain (6,16,26,36) des deux types de transistors,
   l) production de couches d'isolation intercalaires (8,9), ouverture de trous de contact aboutissant aux régions de raccordement de source/drain (7,17,27,37) et aux électrodes de grille (3,13) et exécution, de façon connue, de la métallisation (10).

6. Procédé suivant la revendication 5, caractérisé par le fait qu'entre les étapes opératoires g) et h), on rend préalablement amorphes les régions de source/drain (26,36) par implantation d'ions de silicium.

7. Procédé suivant la revendication 5 ou 6, caractérisé par le fait que lors de l'insertion de substances étrangères, on exécute des implantations doubles en réalisant l'implantation tout d'abord avec une énergie plus faible.

8. Procédé pour fabriquer un circuit intégré à transistors CMOS suivant la revendication 2 ou 4, caractérisé par l'exécution des étapes opératoires suivantes :
   a) production des régions d'oxyde de champ (2) selon le procédé dit LOCOS dans le substrat en silicium (1) pourvu de cuvettes de type p ou de type n pour le type respectif de transistors,

b) exécution de l'oxydation de grille (11,21),

c) dépôt et structuration des électrodes de grille (3,13) du circuit, équipées d'une couche de $SiO_2$ (5,15),

d) dépôt d'une couche de $SiO_2$ (18) et mise en oeuvre d'une technique (19) utilisant une photolaque pour réaliser le masquage, par du $SiO_2$, de la région du transistor comportant les zones de source/drain (26,36) possédant le second type de conductivité,

e) mise à nu, par corrosion anisotrope, des surfaces du substrat prévues pour les zones de source/drain (6,7) possédant le premier type de conductivité,

f) production des oxydes de flanc de grille (5a),

g) élimination du masque de photolaque (19),

h) dépôt épitaxial sélectif d'une couche de silicium monocristallin (4,14) contenant des substances dopantes possédant le premier type de conductivité sur les surfaces du substrat, mises à nu par corrosion, avec une épaisseur de couche dans la gamme de 300 à 500 nm,

i) mise en oeuvre d'un processus d'oxydation pour former un oxyde de protection (20),

j) dépôt d'un masque de photolaque sur les régions du transistor possédant le premier type de conductivité (6,16),

k) mise à nu, par corrosion anisotrope, des surfaces du substrat prévues pour les régions de source/drain (26,36) possédant le second type de conductivité,

l) production de l'oxyde de flanc de grille (15a),

m) élimination du masque de photolaque,

n) dépôt épitaxial sélectif d'une couche de silicium monocristallin (24,34) contenant des substances dopantes possédant le second type de conductivité sur les surfaces du substrat mises à nu par corrosion, avec une épaisseur de couche dans la gamme de 300 à 500 nm,

o) transformation en siliciure des surfaces de source/drain de la couche de silicium épitaxiale (4,14,24,34) après élimination de l'oxyde de protection (20) dans la région du transistor possédant le premier type de conductivité,

p) mise en oeuvre d'une étape de traitement à haute température pour réaliser la diffusion commune des zones de source/drain des deux types de transistors,

q) production de couches d'isolant intercalaires (8,9), ouverture de trous de contact aboutissant aux régions de raccordement de source/drain (7,17,27,37) et aux électrodes de grille (3,13) et exécution, de façon connue, de la métallisation.

9. Procédé suivant l'une des revendications 5 à 8, caractérisé par le fait qu'on utilise du phosphore comme substance dopante pour le premier type de conductivité et du bore comme substance dopante pour le second type de conductivité.

10. Procédé suivant l'une des revendications 5 à 9, caractérisé par le fait que les étapes de traitement en température servant à réaliser la diffusion commune des substances dopantes sont exécutées à 900°C pendant au moins 30 minutes.

11. Procédé suivant l'une des revendications 5 à 10, caractérisé par le fait que la transformation en siliciure des bornes de source/drain (4,14,24,34) s'effectue par dépôt d'un métal à point de fusion élevé, de préférence du tantale ou du titane, par pulvérisation cathodique (Sputtern) et recuit ultérieur.

12. Procédé suivant l'une des revendications 5 à 11, caractérisé par le fait que le dépôt épitaxial de silicium (4,14,24,34) s'effectue à partir de la phase gazeuse par dissociation thermique de silanes halogénés à des pressions faibles.

13. Procédé suivant l'une des revendications 5 à 12, caractérisé par le fait que les processus de corrosion anisotrope sont exécutés au moyen d'une corrosion plasmatique dans une atmosphère contenant de l'oxygène et du fluor.

14. Procédé suivant l'une des revendications 5 à 13, caractérisé par le fait que pour les couches isolantes (8,9) ou les couches d'oxyde de masquage (5,5a,15,15a,20), on utilise une couche de $SiO_2$ produite par dissociation d'orthosilicate de tétraéthyle.

# FIG 1

# FIG 2

## FIG 3

## FIG 4

## FIG 5

## FIG 6

## FIG 7

# FIG 8

# FIG 9

# FIG 10

# FIG 11

# FIG 12